# FASCICULE DE BREVET EUROPEEN

(11) **EP 0 342 094 B1**
(45) Date de publication et mention de la délivrance du brevet: **09.02.1994**
(21) Numéro de dépôt: 89401221.0
(22) Date de dépôt: 28.04.1989
(51) Int. Cl.: H01L 21/76, H01L 23/482, H01L 23/29, H01L 23/66, H01L 27/06

(54) **Circuit intégré hyperfréquence de type planar, comportant au moins un composant mesa, et son procédé de fabrication**
Integrierter Hochfrequenzschaltkreis des Planartyps mit mindestens einem Mesa Bauelement, und sein Herstellungsverfahren
Planar type high frequency integrated circuit comprising at least one Mesa component, and his manufacturing process

(30) Priorité: 10.05.1988 FR 8806278
(43) Date de publication de la demande: 15.11.1989
(73) Titulaire: THOMSON-CSF SEMICONDUCTEURS SPECIFIQUES, 75008 Paris (FR)
(72) Inventeur: Calligaro, Michel, F-92045 Paris La Défense (FR)
(74) Mandataire: Taboureau, James

(56) Documents cités:
- EP-A- 0 109 887
- EP-A- 0 197 861
- DE-A- 2 216 424
- FR-A- 2 508 706
- FR-A- 2 538 616
- R.C.A. REVIEW, vol. 42, no. 4, décembre 1981, pages 522-641, Princeton, New Jersey, US ; L. Ch. UPADHYAYULA et al. : "GaAs Integrated Circuit Developement for Gigabit-Rate-Signal Processing".

## Description

La présente invention est relative à un circuit intégré hyperfréquence, de type planar mais comportant au moins un composant semiconducteur de type mésa. Elle concerne également le procédé de fabrication de ce circuit intégré hyperfréquence.

Les matériaux sur lesquels l'invention peut être appliquée sont les matériaux du groupe III-V, tels que GaAs, AlGaAs ou InP, bien que ceux-ci ne soient pas limitatifs. Elle peut également être appliquée sur le silicium, puisque certaines diodes en silicium de type PIN, Impatt... montent jusqu'à 100 GHz et au delà.

Il est connu qu'en hyperfréquences, les composants mésas, c'est à dire ayant une structure verticale dont les flancs sont dégagés, sont les plus performants. Mais, en raison même de la fréquence, ces composants sont de très petites dimensions, et il est délicat de les assembler sur un substrat céramique ou diélectrique (GaAs semi-isolant par exemple) pour en faire un circuit. Si ces composants mésas sont intégrés dans un circuit intégré planar, d'une part ils font saillie en surface, ce qui ne facilite pas les opérations ultérieures de masquage et de métallisation par exemple, d'autre part leur connexion par la face supérieure du mésa exige des opérations supplémentaires pour que la métallisation de connexion sur le mésa ne court-circuite pas les couches semiconductrices sur les flancs du mésa.

On a déjà proposé un circuit intégré hyperfréquence de type planar, c'est à dire dont la face libre opposée au substrat est très sensiblement plane, circuit intégré dans lequel au moins un composant mésa est enterré dans un caisson creusé dans les couches semiconductrices, et dont un matériau diélectrique remplit ce caisson, autour du composant mésa, de façon à reconstituer une surface plane sur laquelle sont déposées les lignes d'interconnexions. Un tel circuit intégré est décrit dans le document DE-A-2216424.

Selon un objet de l'invention, le matériau diélectrique qui remplit le caisson, autour du composant mésa, a un coefficient de dilatation et une constante diélectrique égaux ou très proches de ceux du matériau semiconducteur.

Selon un autre objet de l'invention, les connexions d'accès au plateau du mésa, prises par une métallisation selon la technique planar, suppriment les selfs de liaisons par fils thermocomprimés, et les lignes microbandes déposées en surface du circuit intégré ont une impédance constante puisque l'épaisseur et la constante diélectrique de leur support sont constantes.

De façon plus précise, l'invention consiste en un circuit intégré hyperfréquence de type planar formé dans une pastille, et comportant au moins un composant de type mésa, porté par un substrat en matériau semi-conducteur semi-isolant, dans lequel le composant mésa est situé dans un caisson creusé dans la pastille du circuit intégré, ce caisson étant rempli, autour du composant mésa, par un diélectrique ayant un coefficient de dilatation thermique et une constante diélectrique sensiblement égaux à ceux du substrat du circuit intégré, et dont la surface supérieure est dans le plan de la surface des composants planar, les interconnexions entre composants planar et mésa étant réalisées, sur la face supérieure de la pastille, au moyen de lignes microbandes en contact direct avec les dits composants tandis que la face inférieure métallisée du substrat constitue un plan de masse pour les lignes microbandes. L'invention consiste aussi en un procédé de fabrication d'un tel circuit intégré, tel que décrit en revendication 7.

L'invention sera mieux comprise par l'exposé plus détaillé d'un exemple de réalisation et de deux exemples de son procédé de fabrication, en s'appuyant sur les figures jointes en annexes, qui représentent :
- figure 1 : vue en coupe d'un circuit intégré hyperfréquence selon l'invention , comportant deux diodes de type mésa.
- figures 2 à 8 : étapes du procédé de fabrication selon l'invention d'un circuit intégré planar comportant au moins deux diodes mésa de types différents,
- figures 9 et 10 : étapes finales du procédé de fabrication selon l'invention d'un circuit intégré planar comportant au moins un transistor planar et une diode mésa.

De façon à en rendre la description plus précise, l'invention sera exposée en s'appuyant sur l'exemple d'un circuit intégré en GaAs, sans que ceci ne constitue une limitation à l'invention qui s'applique à tous les matériaux semiconducteurs convenant aux hyperfréquences.

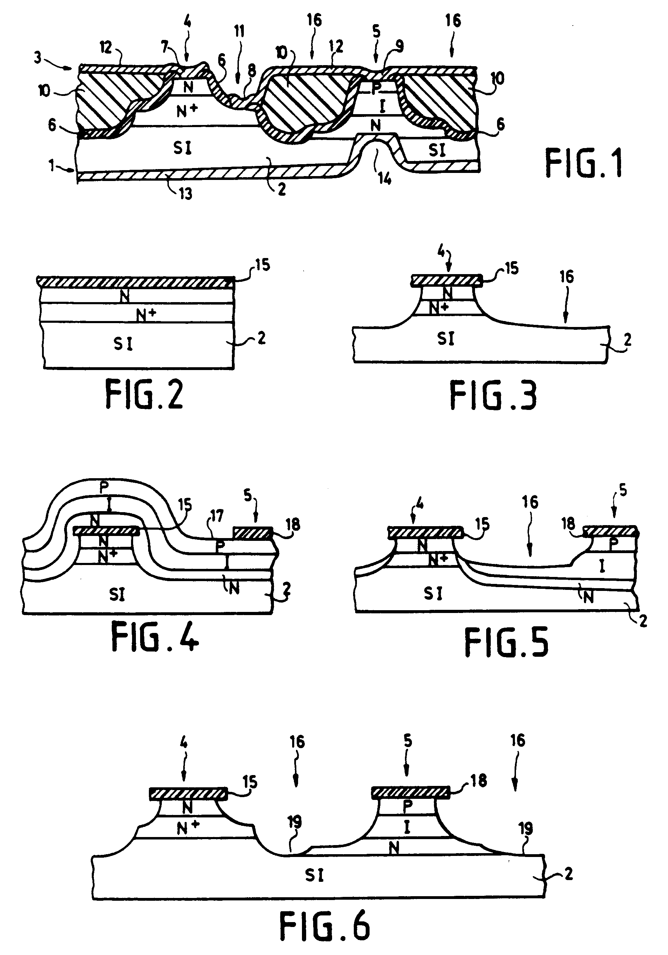

La figure 1 représente une coupe de la partie d'un circuit intégré planar qui comprend au moins un composant semiconducteur mésa : à titre d'exemple non limitatif, ce schéma représente deux diodes, de structures différentes.

Ce circuit intégré est une pastille de GaAs qui comprend deux faces principales : la face 1 du côté du substrat 2, et la face 3, opposée à la précédente et qui est planar. Sa planéité est importante pour minimiser les éléments parasites tels que selfs et capacités aux fréquences millimétriques et en utilisation large bande.

Une région de ce circuit intégré planar comprend un caisson dans lequel sont deux diodes mésa 4 et 5 : le caisson et les mésas sont tels que le plan supérieur des mésas est confondu avec le plan de la face planar 3 du circuit intégré. Chaque mésa est recouvert sur ses flancs par une couche d'arrêt 6, par exemple en nitrure de silicium Si₃ N₄ ouverte seulement aux endroits des prises de contact 7,8 et 9 sur les diodes 4 et 5. Pour conserver la planéité de la face planar 3 du circuit intégré, le caisson est rempli, autour des mésas, par un matériau diélectrique 10, percé si nécessaire pour prendre un contact électrique, en 11 par exemple.

Les métallisations de contact et d'interconnexion sont gravées sur la surface planar 3 du circuit intégré, et elles peuvent être de type microbandes.

En effet, l'invention prévoit que le matériau diélectrique 10 a même coefficient de dilatation que le substrat 2 en GaAs, pour qu'il n'y ait pas destruction du circuit intégré en fonctionnement, et qu'il ait une constante diélectrique ε₁ très proche de la constante diélectrique ε₂ du substrat : par exemple, un verre composé d'oxydes Al₂ O₃ + Z n0 + Si 0₂ de ε₁ = 12 convient avec un substrat de GaAs semi-isolant de ε₂ = 12,5.

Ainsi, entre les lignes microbandes 12 portées par la surface planar 3 du circuit intégré, et leur plan de masse 13 constitué par une métallisation de la surface 1 du substrat, l'épaisseur et la constante diélectrique des différents matériaux, GaAs ou verre, sont constantes,: il n'y a pas de variations de l'impédance des lignes microbandes.

Dans un composant mésa, les contacts électriques sont, par définition, pris dans deux plans différents. Dans l'exemple choisi pour exposer l'invention, un premier composant 4 a un premier contact 7 pris dans le plan 3 et un second contact 8 pris sur une couche inférieure, dans le fond d'un puits 11 creusé dans le diélectrique 10. Un second composant 5 a un premier contact 9 pris dans le plan 3 et un second contact pris par la face arrière au moyen d'un trou 14 percé dans le substrat 2.

Le détail structurel des composants mésa 4 et 5 n'est pas précisé. L'invention concerne au moins un composant mésa noyé dans un diélectrique qui remplit un caisson dans un circuit intégré planar. Ce composant peut être une diode ou un transistor, et être composé d'un nombre de couches qui sort du domaine de l'invention. Une diode Schottky réalisée sur les couches N-N⁺ et une diode PIN ne sont représentées que pour concrétiser l'invention.

La description du procédé de fabrication de ce circuit intégré permettra de mieux comprendre sa structure.

Le produit de départ, en figure 2, est une plaquette de substrat 2, en GaAs semi-isolant, sur laquelle on fait croître par une première épitaxie par exemple les deux couches de GaAs N et N⁺ dans lesquelles sera réalisée la diode 4 de la figure 1. Leur épaisseur totale est de l'ordre de 2 microns. Puis on dépose sur cette plaquette épitaxiée une première couche d'arrêt 15, par exemple en nitrure de silicium, sur 200 nm (2000 Å) d'épaisseur.

Dans la seconde étape, en figure 3, un masquage approprié permet de conserver les régions de la couche d'arrêt 15 qui protègent la future diode 4 et les parties planar du circuit intégré (hors du champ de la figure). Après développement, une gravure crée un caisson 16 dont la profondeur de l'ordre de 4 microns est égale à celle du composant 5, et atteint le substrat 2.

En tout état de cause, l'épitaxie préliminaire concerne le ou les composants les plus fins, et la gravure du caisson concerne le ou les composants les plus épais. S'il en était autrement, le composant 5 reposerait sur la couche épitaxiée la plus profonde du composant 4.

Une seconde épitaxie, sur toute la surface de la plaquette, en figure 4, fournit la ou les couches actives du composant 5. On y a représenté trois couches de GaAs dopées P,I et N puisqu'on a choisi comme exemple de composant mésa 5 une diode PIN. Ces couches recouvrent toute la plaquette, y compris le composant 4, mais il est important que leur surface supérieure 17 soit dans le même plan que la surface supérieure des couches de la première épitaxie.

Sur cette surface supérieure 17 est déposée une seconde couche d'arrêt 18, par exemple en nitrure de silicium, sur 200 nm (2000 Å) d'épaisseur. Après masquage, elle est gravée pour ne conserver que la région qui recouvre et protège le futur composant mésa 5.

A ce point du procédé de fabrication, le circuit intégré n'est plus planar : il comporte les couches épitaxiées qui surmontent les régions planar, et qui sont les couches P,I,N représentées en figure 4 à titre d'exemple. Il faut donc retrouver la surface planar du circuit intégré soit par polissage mécano-chimique, soit par gravure chimique. La figure 5 montre l'état du circuit intégré après planarisation par une gravure chimique : il y a une légère attaque des couches épitaxiées au dehors des régions protégées par les couches d'arrêt 15 et 18.

La gravure chimique est poursuivie de façon à éliminer, comme montré en figure 6, les couches de la deuxième épitaxie situées entre le composant planar 4 et le futur composant mésa 5. Cette gravure, qui crée le mésa, est poursuivie jusqu'à atteindre en 19 le substrat 2 : la structure verticale du mésa 5 est donc isolée.

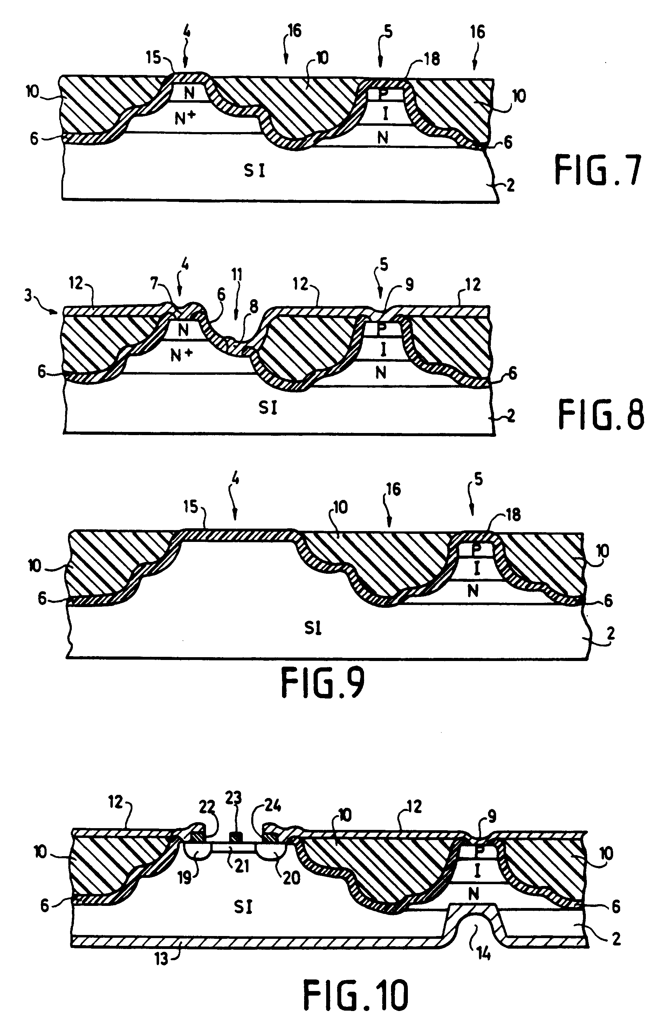

Les flancs d'une structure mésa sont très généralement protégés par une couche de passivation. Le dépôt d'une couche 6 de nitrure de silicium par exemple constitue la première étape montrée en figure 7. Cette couche recouvre également les flancs des régions planar, ainsi que les surfaces supérieures, mais cela ne présente pas d'inconvénient : au contraire, cette passivation protège les couches de matériaux III-V contre l'oxygène contenu dans le verre de l'étape suivante.

La seconde étape de cette même figure consiste en un dépôt planarisé, dans le caisson 16, d'un diélectrique 10 en poudre de verre frittée : selon l'invention, ce diélectrique a sensiblement même coefficient de dilatation thermique et même constante diélectrique que le substrat du circuit intégré. Si celui-ci est en GaAs semi-isolant, un verre composé d'un mélange d'oxydes Al₂ 0₃ + Zn 0 + Si0₂ convient bien. Le diélectrique 10 est poli si nécessaire pour le planariser.

La surface planar est alors masquée puis gravée pour ouvrir dans la couche 6 de passivation des fenêtres de prises de contact électrique, sur les couches supérieures des composants 4 et 5. Si nécessaire, une ouverture en 11 peut être pratiquée dans la couche 6 de passivation, pour aller prendre un contact électrique 8 sur une couche inférieure d'un composant.

Enfin, comme représenté en figure 8, les interconnexions ou lignes microbandes 12 sont déposées et gravées sur la surface planar 3 du circuit intégré. Les lignes microbandes 12 ont une impédance constante : en effet, le diélectrique 10 obture le caisson 16 autour du mésa, et il a même constante diélectrique que le substrat 2. Il y a donc une épaisseur constante et sans variation de constante diélectrique entre les lignes microbandes 12 et le plan de masse qui reste à déposer, sur la face inférieure du substrat.

Le circuit intégré représenté achevé en figure 1, subit d'abord un rodage du substrat 2 par sa face inférieure, ce qui permet d'ajuster l'impédance des lignes microbandes, puisqu'on sait que cette impédance dépend entre autres de l'épaisseur de diélectrique entre ligne et plan de masse. Mais cet amincissement facilite également le perçage en 14 d'un trou de reprise de contact sur la structure mésa 5, par la face arrière du circuit intégré. Ce trou 14 est percé chimiquement par des procédés bien connus, et il traverse le substrat 2, jusqu'à atteindre la couche la plus profonde du composant mésa 5.

Il ne reste plus qu'à déposer une métallisation 13 de plan de masse sur la face arrière du substrat 2 et dans le trou 14 de reprise de contact pour achever le circuit intégré selon l'invention : c'est un circuit planar parce que sa surface supérieure est plane, mais il comporte au moins un composant mésa, "enterré" dans un caisson rebouché avec un diélectrique.

Le circuit intégré selon l'invention et son procédé de fabrication ont été exposés dans le cas où au moins un composant planar comporte des couches épitaxiées : c'est la diode Schottky sur jontion N-N⁺. Les figures 9 et 10 donnent les étapes finales du procédé de fabrication dans le cas où les composants planar sont implantés.

Le procédé reste conforme, dans ses premières étapes, à ce qui a été exposé pour les figures 2 à 6, à l'exclusion de la première épitaxie des couches N et N⁺, qui n'a pas de raison d'être puisque les composés planar sont implantés. Dans ces conditions, le procédé aboutit à la structure de la figure 9, qui est le pendant de la figure 7 dans le cas précédent.

Les surfaces planar 15 et 18 de la couche d'arrêt 6 sont alors masquées et gravées : en 15 pour dégager par exemple la surface d'un transistor à implanter, et en 18 pour dégager une reprise de contact sur la diode mésa 5. Puis, en figure 10, au moins un transistor planar 4 est implanté : le détail des régions implantées n'a pas à être explicité içi, car il sort du domaine de l'invention. Ce sont par exemple deux caissons 19 et 20 d'accès de source et de drain, et un canal 21. Les métallisations de source 22, de grille 23 et de drain 24 sont déposées selon les règles de l'art sur les régions implantées correspondantes.

Le procédé se termine, comme précédemment, par l'amincissement du substrat 2, afin d'ajuster l'impédance des lignes microbandes, et le dépôt et gravure des métallisations 12 et 13 sur les deux faces, avec si nécessaire une reprise de contact en 14, par la face arrière.

Le procédé selon l'invention permet de réaliser des circuits microbandes sur des puces de circuit intégré hyperfréquence planar comportant au moins un composant à structure mésa, qui est enterré dans un caisson ensuite bouché par un diélectrique. Les accès supérieurs par lignes microbandes aux composants suppriment les selfs de liaisons qui, dans l'art connu, sont créées par les fils ou ponts à air.

Le procédé selon l'invention est utilisé pour réaliser des mélangeurs monolithiques à diodes Schottky et diodes PIN de protection, des oscillateurs VCO à transistors et diode varicap, des limiteurs ou des commutateurs à N voies, sous forme de circuit intégré planar.

## Revendications

1. Circuit intégré hyperfréquence de type planar formé dans une pastille, et comportant au moins un composant de type mésa, porté par un substrat (2) en matériau semi-conducteur semi-isolant, dans lequel le composant mésa (5) est situé dans un caisson (16) creusé dans la pastille du circuit intégré, ce caisson (16) étant rempli, autour du composant mésa (5), par un diélectrique (10) ayant un coefficient de dilation thermique et une constante diélectrique sensiblement égaux à ceux du substrat (2) du circuit intégré et dont la surface supérieure est dans le plan de la surface (3) des composants planar, les interconnexions entre composants planar et mésa (5) étant réalisées, sur la face supérieure (3) de la pastille, au moyen de lignes microbandes (12) en contact direct (7,8,9) avec les dits composants, tandis que la face inférieure (1) métallisée du substrat (2) constitue un plan de masse (13) pour les lignes microbandes (12).

2. Circuit intégré selon la revendication 1, caractérisé en ce que le diélectrique (10) est un verre de Al₂ 0₃ + Si 0₂ + Zn0, dans le cas où le substrat (2) est en GaAs.

3. Circuit intégré selon la revendication 1 caractérisé en ce que la profondeur de creusement du caisson (16) est égale à la hauteur du composant mésa (5), et atteint le substrat (2) semi-isolant.

4. Circuit intégré selon la revendication 1, caractérisé en ce que les flancs du caisson (16) et du composant mésa (5) sont recouverts par une couche de passivation (6) en matériau diélectrique.

5. Circuit intégré selon la revendication 1, caractérisé en ce que, entre les deux faces planes (1,3) du circuit intégré, l'épaisseur et la constante diélectrique des matériaux (2,10) qui séparent les lignes microbandes (12) de leur plan de masse (13) est constante.

6. Circuit intégré selon la revendication 5, caractérisé en ce que l'épaisseur du substrat (2) est choisie et ajustée pour définir une impédance caractéristique aux lignes microbandes (12+13)

7. Procédé de fabrication d'un circuit intégré hyperfréquence selon la revendication 1, caractérisé en ce qu'il comporte les étapes suivantes :
a) protection de la surface planar (3) de la pastille de circuit intégré par une couche d'arrêt (15) en diélectrique tel que Si₃ N₄, masquage et gravure de cette couche d'arrêt (15), la région du futur composant mésa (5) et du caisson (16) qui l'entoure étant ainsi dégagée,
b) creusement par gravure du caisson (16), jusqu'à une profondeur égale à la hauteur du futur composant mésa (5),
c) épitaxie sur toute la surface de la pastille des couches de matériaux semi-conducteurs, constitutives du composant mésa (5), sur une épaisseur égale à la profondeur du caisson (16),
d) dépôt d'une seconde couche d'arrêt (18) en diélectrique tel que Si₃ N₄, masquage et gravure de cette couche d'arrêt (18), le caisson (16) étant ainsi dégagé mais la région du futur composant mésa (5) restant masquée,
e) gravure des couches épitaxiées déposées dans le caisson (16), sauf celles masquées (18), jusqu'à atteindre (19) le substrat semi-isolant (2),
f) passivation des flancs du mésa (5) par une couche (6) de diélectrique tel que Si₃ N₄, et remplissage du caisson (16) par un diélectrique (10) ayant sensiblement même coefficient de dilatation thermique et même constante diélectrique que le substrat (2),
g) planarisation du diélectrique (10) qui remplit le caisson (16), ouverture de fenêtres de reprise de contacts électriques (7,8,9) sur les composants planar et mésa (5) dans la couche de passivation (6) par masquage et gravure, et réalisation des interconnexions en lignes microbandes (12),
h) amincissement du substrat (2) par sa face arrière (1), l'impédance des lignes microbandes (12) étant ainsi ajustée,
i) perçage d'un trou (14) de reprise de contact sur le composant mésa (5), par la face arrière (1) du substrat semi-isolant (2),
j) dépôt sur la face arrière (1) du substrat (2) de la métallisation de plan de masse (13).

## Claims

1. Microwave integrated circuit of planar type formed in a chip, comprising at least one component of the mesa type, carried by a substrate (2) made of a semi-insulating semiconductor material, in which the mesa component (5) is situated in a housing (16) hollowed into the chip of the integrated circuit, this housing (16) being filled, around the mesa component (5), by a dielectric (10) having a coefficient of thermal expansion and a dielectric constant substantially equal to those of the substrate (2) of the integrated circuit, and whose upper surface is in the plane of the surface (3) of the planar components, the interconnections between the planar components and mesa (5) being made, on the upper surface (3) of the chip, by means of microstrip lines (12) in direct contact (7, 8, 9) with the said components, whilst the lower metallized face (1) of the substrate (2) constitutes an earth plane (13) for the microstrip lines (12).

2. Integrated circuit according to Claim 1, characterized in that the dielectric (10) is an Al₂O₃ + SiO₂ + ZnO glass, in the case in which the substrate (2) is made of GaAs.

3. Integrated circuit according to Claim 1, characterized in that the depth of the hollowing of the housing (16) is equal to the height of the mesa component (5), and reaches the semi-insulating substrate (2).

4. Integrated circuit according to Claim 1, characterized in that the flanks of the housing (16) and of the mesa component (5) are covered with a passivation layer (6) made of a dielectric material.

5. Integrated circuit according to Claim 1, characterized in that, between the two plane faces (1, 3) of the integrated circuit, the thickness and the dielectric constant of the materials (2, 10) which separate the microstrip lines (12) from their earth plane (13) is constant.

6. Integrated circuit according to Claim 5, characterized in that the thickness of the substrate (2) is chosen and adjusted to define a characteristic impedance for the microstrip lines (12 + 13).

7. Method for manufacturing a microwave integrated circuit according to Claim 1, characterized in that it comprises, in steps:
a) protecting the planar surface (3) of the integrated circuit chip with a barrier layer (15) made of a dielectric such as Si₃N₄, masking and etching of this barrier layer (15), the region of the future mesa component (5) and of the housing (16) which surrounds it thus being uncovered,
b) hollowing the housing (16) by etching, to a depth equal to the height of the future mesa component (5),
c) epitaxy over the entire surface of the chip of the layers of semiconductor materials constituting the mesa component (5), over a thickness equal to the depth of the housing (16),
d) deposition of a second barrier layer (18) made of a dielectric such as Si₃N₄, masking and etching of this barrier layer (18), the housing (16) being thus uncovered but the region of the future mesa component (5) remaining masked,
e) etching of the epitaxially grown layers deposited in the housing (16), with the exception of the masked ones (18), until reaching (19) the semi-insulating substrate (2),
f) passivation of the flanks of the mesa (5) with a layer (6) of dielectric such as Si₃N₄, and filling of the housing (16) with a dielectric (10) with substantially the same coefficient of thermal expansion and the same dielectric constant as the substrate (2),
g) planing of the dielectric (10) which fills the housing (16), for opening electrical contact takeup windows (7, 8, 9) on the planar components and the mesa (5) in the passivation layer (6) by masking and etching, and making the interconnections from microstrip lines (12),
h) thinning the substrate (2) through its rear face (1), the impedance of the microstrip lines (12) thus being adjusted,
i) piercing a contact takeup hole (14) on the mesa component (5) through the rear face (1) of the semi-insulating substrate (2),
j) deposition on the rear face (1) of the substrate (2) of the metallization of the earth plane (13).

## Patentansprüche

1. In einem Plättchen gebildete Höchstfrequenzschaltung vom Planartyp mit wenigstens einem Mesa-Bauelement auf einem Substrat (2) aus einem halbisolierenden Halbleitermaterial, in dem das Mesa-Bauelement (5) in einer in dem Plättchen der integrierten Schaltung vertieften Wanne (16) gebildet ist, wobei die Wanne (16) um das Mesa-Bauelement (5) herum mit einem Dielektrikum (10) ausgefüllt ist, das einen Wärmeausdehnungskoeffizienten und eine Dielektrizitätskonstante im wesentlichen gleich den entsprechenden Parametern des Substrats (2) der integrierten Schaltung hat und dessen obere Fläche in der Ebene der Oberfläche (3) der planaren Bauelemente liegt, wobei die Verbindungen zwischen planaren Mesa-Bauelementen (5) auf der oberen Fläche (3) des Plättchens mit Hilfe von Mikrostreifenleitungen (12) verwirklicht sind, die mit den Bauelementen in direktem Kontakt (7, 8, 9) stehen, während die metallisierte untere Fläche (1) des Substrats (2) eine Masseebene (13) für die Mikrostreifenleitungen (12) bildet.

2. Integrierte Schaltung nach Anspruch 1, dadurch gekennzeichnet, daß das Dielektrikum ein (Al₂O₃ + SiO₂ + ZnO)-Glas für den Fall ist, daß das Substrat (2) aus GaAs besteht.

3. Integrierte Schaltung nach Anspruch 1, dadurch gekennzeichnet, daß die Aushöhlungstiefe der Wanne (16) gleich der Höhe des Mesa-Bauelements (5) ist und das halbisolierende Substrat (2) erreicht.

4. Integrierte Schaltung nach Anspruch 1, dadurch gekennzeichnet, daß die Flanken der Wanne (16) und des Mesa-Bauelements (5) mit einer Passivierungsschicht (6) aus dielektrischem Material überzogen sind.

5. Integrierte Schaltung nach Anspruch 1, dadurch gekennzeichnet, daß zwischen den zwei ebenen Flächen (1, 3) der integrierten Schaltung die Dicke und die Dielektrizitätskonstante der Materialien (2, 10), die die Mikrostreifenleitungen (12) von der Masseebene (13) trennen, konstant sind.

6. Integrierte Schaltung nach Anspruch 5, dadurch gekennzeichnet, daß die Dicke des Substrats (2) so gewählt und eingestellt ist, daß eine charakteristische Impedanz der Mikrostreifenleitungen (12+13) festgelegt wird.

7. Verfahren zum Herstellen einer integrierten Höchstfrequenzschaltung nach Anspruch 1, dadurch gekennzeichnet, daß es folgende Stufen enthält:
a) Schützen der ebenen Fläche (3) des Plättchens der integrierten Schaltung durch eine Blockierschicht (15) aus einem Dielektrikum wie Si₃N₄, Maskieren und Ätzen dieser Blockierschicht (15), wobei der Bereich des zukünftigen Mesa-Bauelements (5) und der dieses umgebenden Wanne (16) auf diese Weise freigelegt werden,
b) Vertiefen der Wanne (16) durch Ätzen bis zu einer Tiefe, die gleich der Höhe des zukünftigen Mesa-Bauelements (5) ist,
c) epitaktisches Aufbringen von Schichten aus das Mesa-Bauelement (5) bildenden Halbleitermaterialien auf der gesamten Oberfläche des Plättchens mit einer Dicke, die gleich der Tiefe der Wanne (16) ist,
d) Aufbringen einer zweiten Blockierschicht (18) aus einem Dielektrikum wie Si₃N₄, Maskieren und Ätzen dieser Blockierschicht (18), wobei auf diese Weise die Wanne (16) freigelegt wird, während die Zone des zukünftigen Mesa-Bauelements (5) maskiert bleibt,
e) Ätzen der epitaktisch aufgebrachten Schichten in der Wanne (16), abgesehen von denen, die maskiert sind (18), bis zum Erreichen des halbisolierenden Substrats (2),
f) Passivieren der Flanken des Mesa (5) durch eine dielektrische Schicht (6) wie Si₃N₄ und Füllen der Wanne (16) mit einem Dielektrikum (10), das im wesentlichen den gleichen Wärmeausdehnungskoeffizienten und die gleiche Dielektrizitätskonstante wie das Substrat (2) hat,
g) Planarisieren des Dielektrikums (10), das die Wanne (16) ausfüllt, Öffnen von elektrischen Kontaktfenstern (7, 8, 9) über den planaren Mesa-Bauelementen (5) in der Passivierungsschicht (6) durch Maskieren und Ätzen und Erzeugen von Verbindungen aus Mikrostreifenleitungen (12),
h) Verdünnen des Substrats (2) an seiner Hinterfläche (1), wobei die Impedanz der Mikrostreifenleitungen (12) auf diese Weise eingestellt wird,
i) Erzeugen eines Lochs (14) als Kontaktzugang über dem Mesa-Bauelement (5) durch die Rückfläche (1) des halbisolierenden Substrats (2),
j) Aufbringen der Metallisierung der Masseebene (13) auf der Rückfläche (1) des Substrats (2).
